Europäisches Patentamt

European Patent Office

Office européen des brevets

(11) Numéro de publication: **0 108 012**
**A1**

## DEMANDE DE BREVET EUROPEEN

(21) Numéro de dépôt: **83402046.3**

(22) Date de dépôt: **21.10.83**

(51) Int. Cl.³: **G 01 R 15/07**

(30) Priorité: 28.10.82 FR 8218101
18.01.83 FR 8300693

(43) Date de publication de la demande:
**09.05.84 Bulletin 84/19**

(84) Etats contractants désignés:
**DE GB NL**

(71) Demandeur: **COMMISSARIAT A L'ENERGIE ATOMIQUE**
**Etablissement de Caractère Scientifique Technique et**
**Industriel**
**31/33, rue de la Fédération**
**F-75015 Paris(FR)**

(72) Inventeur: **Langeac, Daniel**
**4, Place Jean Moulin**
**F-38000 Grenoble(FR)**

(74) Mandataire: **Mongrédien, André et al,**
**c/o BREVATOME 25, rue de Ponthieu**
**F-75008 Paris(FR)**

(54) Dispositif de mesure d'intensité électrique à effet Faraday.

(57) Dispositif de mesure d'intensité électrique à effet Faraday.

Il comprend un fibre optique (2) torsadée le long de son axe et enroulée en solénoïde autour du conducteur électrique (1) dans lequel circule l'intensité à mesurer, ainsi qu'à l'entrée (3) et à la sortie (6) de la fibre (2) respectivement une source de lumière polarisée (5) et des moyens de mesure (7, 8, 9, 10) de l'angle de rotation du plan de polarisation de cette lumière.

La fibre (2) comporte au moins deux parties torsadées en sens opposés, le nombre de tours de torsion de l'ensemble de la fibre dans un sens étant égal au nombre de tours de torsion dans l'autre sens.

FIG. 3

La présente invention se rapporte à la mesure des courants électriques par effet Faraday et trouve une application plus particulièrement dans le cas où cette mesure a lieu dans un environnement difficile.

Le dispositif, objet de l'invention, met en oeuvre les techniques connues de mesures magnéto-optiques de courant, qui permettent de faire de telles mesures à l'abri des problèmes d'isolation électrique et de perturbations électromagnétiques, problèmes que l'on rencontre notamment dans la mesure de courants industriels parcourant des conducteurs portés à une tension élevée par rapport à la terre ; il permet également de s'affranchir des variations de température qui affectent éventuellement l'environnement où se fait la mesure.

L'effet magnéto-optique utilisé est l'effet Faraday selon lequel le plan de polarisation d'un faisceau lumineux, polarisé linéairement, tourne d'un angle $\omega$ sous l'effet d'un champ magnétique H créé par le courant à mesurer et proportionnel à l'intensité I de ce dernier. L'angle $\omega$ de rotation du plan de polarisation de la lumière soumis au champ magnétique H est, en première approximation, proportionnel à ce champ et donc à l'intensité I qui lui a donné naissance. On conçoit par conséquent facilement la possibilité de réaliser, en utilisant cet effet Faraday connu, un dispositif de mesure d'intensité électrique.

En effet, de façon plus précise, l'angle $\omega$ de rotation du plan de polarisation de la lumière est donné par la formule :

$$\omega = V_e \int \vec{H} \cdot \vec{d\ell}$$

formule dans laquelle : $\vec{H}$ est le champ magnétique créé par le courant I à mesurer et auquel on soumet précisément un échantillon de lumière polarisée ; $\ell$ est la longueur d'interaction entre le champ et le parcours du rayon lumineux polarisé ; $V_e$ est une constante spécifique du milieu, appelée constante de Verdet. Cette constante est importante pour les corps ferromagnétiques et faible pour les corps diamagnétiques, tels que les fibres optiques. Il est important par ailleurs de noter que, pour les milieux diamagnétiques, elle est indépendante de la température.

D'après le théorème d'Ampère, on peut écrire :

$$\int \vec{H} \cdot \vec{d\ell} = N.I$$

sur une courbe fermée, N étant le nombre de tours de la lumière autour du conducteur parcouru par l'intensité I.

Ce qui revient à écrire $\omega = V_e.N.I$, formule qui établit la proportionnalité du courant I et de l'angle $\omega$ .

Des dispositifs ampèremétriques de mesure d'intensité électrique bâtis sur l'effet Faraday sont décrits notamment dans les articles suivants :

(1) "Mesure d'un courant par un ampèremètre à effet Faraday" par P.HEROIN, Ch. BENOIST et Y. DE LA MARRE, publié dans la Revue Générale de l'Electricité, juillet-août 1967, p. 1045 ;

(2) "Optical Fibers for Current Measurement Applications" par A.M. SMITH, publié dans la Revue Optics and Laser Technology, février 1980, p. 25.

Dans cette technique, il a été proposé, pour mesurer le courant dans un conducteur, d'enrouler une fibre optique monomode autour du conducteur, de manière à augmenter la longueur d'interaction entre le champ magnétique et l'onde lumineuse se propageant B 7642-3 AM dans la fibre optique. De ce fait, on peut compenser la valeur faible de la constante de Verdet dans un milieu diamagnétique par une grande longueur d'interaction magnéto-optique et bénéficier de l'invariance de cette constante avec la température dans un tel milieu.

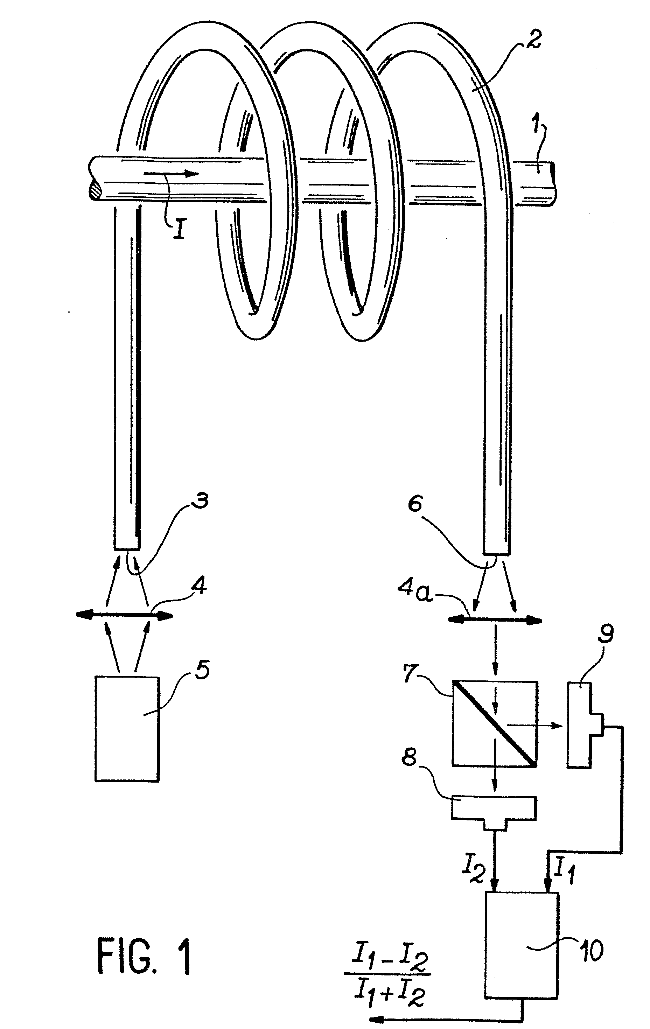

Un dispositif de mesure d'intensité électrique par effet Faraday d'un type en soi connu est représenté sur la figure 1 ci-jointe. Il comporte, enroulée à la manière d'un solénoïde autour d'un conducteur 1 parcouru par un courant électrique I que l'on veut mesurer, une fibre optique 2 du type monomode et comportant une ou plusieurs spires autour du conducteur 1. L'extrémité d'entrée 3 de la fibre optique 2 est couplée par une lentille 4 à une source lumineuse polarisée linéairement qui peut être avantageusement par exemple une diode laser 5. L'extrémité de sortie 6 de la fibre optique 2 est suivie d'une lentille 4a et d'un dispositif d'analyse de la rotation du plan de polarisation de la lumière ayant parcouru la fibre optique 2 depuis son entrée en 3 dans celle-ci.

Ce dispositif peut être par exemple un prisme de Wollaston donnant deux faisceaux lumineux, d'intensités respectives $I_1$ et $I_2$, polarisés linéairement et orthogonalement, reçus par des moyens de détection de lumière connectés à un circuit électronique analogique calculant l'expression $P = (I_1-I_2)/(I_1+I_2)$. Il est connu que cette expression P est égale à $\sin 2\omega$, valeur voisine de $2\omega$ lorsque $\omega$ est faible, ce qui est généralement le cas pour les champs magnétiques engendrés par les courants que l'on veut mesurer (par exemple, les courants circulant dans les réseaux de distribution électrique). Le circuit électronique fournit donc un signal proportionnel à l'intensité I à mesurer.

Le dispositif d'analyse de la polarisation lumineuse à la sortie 6 de la fibre 2 peut être aussi bien d'ailleurs un cube séparateur associé à deux polariseurs croisés ou, comme c'est le cas sur la figure 1, un cube séparateur polariseur 7 associé à deux photodiodes 8 et 9 détectant chacune des intensités $I_1$ et $I_2$ des deux faisceaux lumineux polarisés linéairement et orthogonalement. Une unité électronique analogique 10 calcule ensuite le rapport

$$P = \frac{I_1 - I_2}{I_1 + I_2}$$

dont il a été question précédemment et qui est représentatif de l'intensité I à mesurer dans le conducteur 1.

Malheureusement, le dispositif connu de la figure 1 ne permet pas d'obtenir des mesures précises et cohérentes si l'on ne prend pas la précaution de s'affranchir des phénomènes de biréfringence linéaire parasite qui sont causés par de nombreux phénomènes (procédé de fabrication, courbure de la fibre, variation de température) dans une fibre optique classique monomode. Ces phénomènes parasites de biréfringence linéaire ont notamment l'inconvénient grave de détruire la linéarité de la polarisation de l'onde lumineuse au cours de son trajet dans la fibre optique.

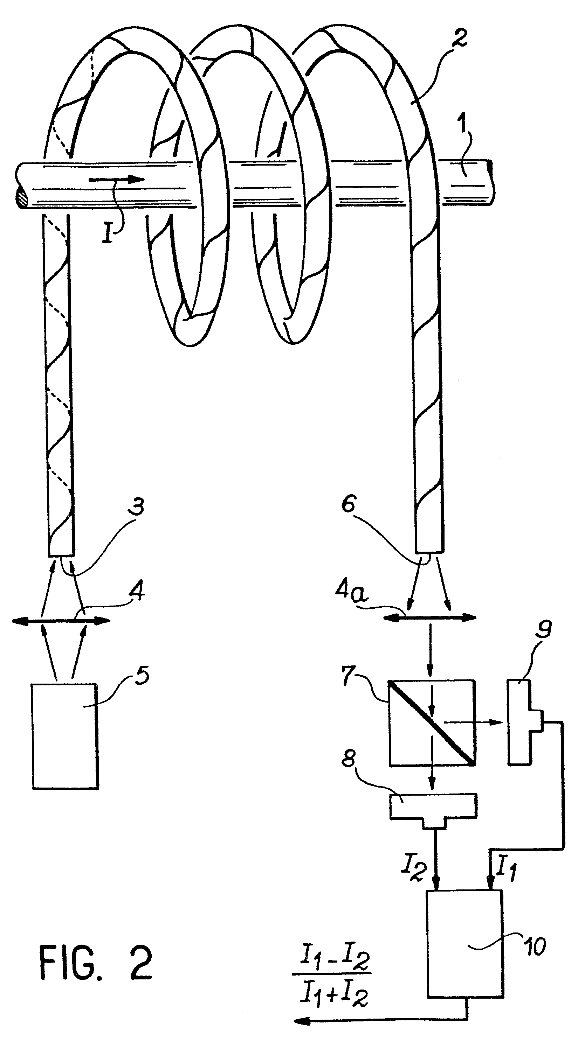

Pour lutter contre cette difficulté, on a déjà proposé une solution qui consite à torsader la fibre optique autour de son axe longitudinal pour annuler macroscopiquement les phénomènes de biréfringence précédents. Un tel dispositif également connu est représenté sur la figure 2 où l'on retrouve tous les éléments de la figure 1 à ceci près que, comme l'indique schématiquement le profil d'une génératrice de la surface de la fibre optique alternativement en trait plein et en trait pointillé, cette dernière a été torsadée longitudinalement avant d'être enroulée sous forme de solénoïde autour du conducteur 1 dans lequel passe l'intensité I à mesurer.

Le dispositif de la figure 2 ne représente toutefois qu'une étape dans l'amélioration des défauts du dispositif de la figure 1. En effet, si ce dispositif permet de conserver son caractère linéaire à la polarisation de l'onde lumineuse traversant la fibre 2, la torsion de cette fibre optique provoque en revanche une activité optique, en l'occurrence une rotation naturelle du plan de polarisation de la lumière, qui varie en fonction de la température. Il en résulte par conséquent que si l'on utilise un dispositif comportant la compensation de la figure 2 dans un milieu où la température évolue, sans prendre de précaution spéciale pour éliminer l'influence de cette température, il est impossible de distinguer dans la rotation du plan de polarisation la composante qui est due à ces variations de température et la composante due à l'effet Faraday proprement dit. En d'autres termes, le dispositif de la figure 2 est impropre à réaliser une mesure d'intensité électrique dans une ambiance à température variable.

La présente invention a pour objet précisément un dispositif de mesure d'intensité électrique à effet Faraday qui permet d'éliminer, d'une manière simple, l'influence néfaste de la température dans les dispositifs de mesure d'intensité électrique à l'aide d'une fibre optique torsadée, enroulée en solénoïde autour du conducteur parcouru par cette intensité.

Ce dispositif, du genre de ceux qui comprennent de façon connue une fibre optique torsadée le long de son axe et enroulée en solénoïde autour du conducteur électrique dans lequel circule l'intensité à mesurer, ainsi qu'à l'entrée et à la sortie de la fibre respectivement une source de lumière polarisée et des moyens de mesure de l'angle de rotation du plan de polarisation de cette lumière, parcourant la fibre, entre son entrée et sa sortie, se caractérise en ce que la fibre comporte au moins deux parties torsadées en sens opposés, le nombre de tours de torsion de l'ensemble de la fibre dans un sens étant égal au nombre de tours de torsion dans l'autre sens.

On comprend aisément que l'équilibrage des nombres de tours de torsion imposés à la fibre dans les deux sens opposés provoque une compensation des rotations du plan de polarisation causées par une variation de température du milieu ambiant. D'une manière plus générale, pour obtenir l'effet de compensation recherché en température, il faut et il suffit que le nombre de tours de torsion résultant soit nul. On obtient de cette manière un dispositif qui s'affranchit d'une part des effets de biréfringence linéaire en imposant une torsion à la fibre optique, et d'autre part, des effets de température grâce à la torsion résultante nulle de la fibre autour de son axe longitudinal.

Dans un mode de réalisation spécialement simple de la présente invention, la fibre comporte deux parties d'égale longueur, torsadée chacune dans un sens, le sens de torsion changeant une seule fois au point milieu de la longueur de la fibre.

Pour obtenir un dispositif conforme à cette réalisation, il suffit d'immobiliser en le fixant, d'une manière quelconque, le point milieu de la fibre et d'imposer ensuite à celle-ci, à chacune de ses extrémités, un nombre de torsions égal et de sens opposés.

Dans un autre mode de mise en oeuvre, du dispositif objet de l'invention, la fibre comporte plusieurs parties adjacentes, le sens de torsion de la fibre s'inversant à chaque point de jonction entre deux parties consécutives. On peut en effet, selon les cas particuliers, choisir d'imposer les torsions dextrogyre et sinistrogyre à la fibre optique de façon irrégulière ou localisée, l'essentiel étant que la torsion résultante soit nulle.

Enfin, selon un mode perfectionné de réalisation de l'invention, la fibre optique est bloquée à ces deux extrémités et est enfermée dans une gaine extérieure destinée à compenser les réactions mécaniques dues aux diverses torsions. La présence d'une telle gaine extérieure facilite effectivement d'une part le maintien des torsions imposées dans un sens et dans l'autre localement dans la fibre optique et d'autre part, empêche tout glissement ou déformation de celles-ci selon l'axe de la fibre optique au cours du temps.

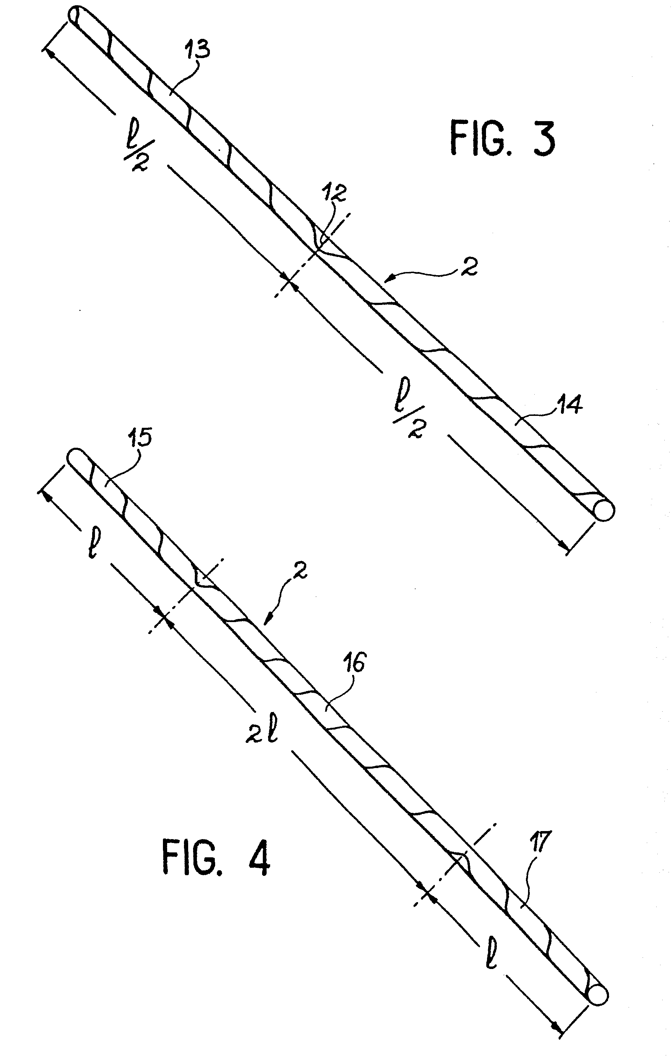

De toute façon l'invention sera mieux comprise en se référant à la description qui suit d'un exemple de mise en oeuvre du dispositif de mesure d'intensité électrique, description qui sera faite à titre explicatif et non limitatif en se référant aux figures 3 et 4 sur lesquelles :

- la figure 3 représente de façon schématique et linéaire une fibre optique torsadée selon l'invention ;
- la figure 4 représente une autre fibre optique torsadée selon l'invention, mais comportant plusieurs zones de torsion de sens différent,
- la figure 5 représente une installation perfectionnée de mesure d'intensité électrique par effet Faraday, insensible aux courbures et aux vibrations imposées aux fibres optiques.

B 7642-3 AM

Les fibres optiques des figures 3 et 4 sont représentées pour plus de simplicité concernant le dessin en position linéaire, mais il est bien entendu que, pour constituer le dispositif de mesure d'intensité électrique, objet de l'invention, elles sont en réalité enroulées autour du conducteur 1 parcouru par l'intensité I à mesurer de la même façon que dans le dispositif de la figure 2.

Sur la figure 3 on a représenté sous forme déployée une fibre optique 2 comportant à partir de son point milieu 12 deux moitiés d'égale longueur 13 et 14. Ces deux moitiés 13 et 14 de fibre optique sont torsadées, ainsi que le suggère en traits pleins le profil approximatif d'une génératrice longitudinale de la fibre, dans des sens opposés et comportent le même nombre de tours de torsion. La fibre 2 ainsi constituée est prête à être utilisée dans un dispositif de mesure d'intensité électrique conçu comme celui de la figure 2 mais qui ne réagira plus cette fois aux variations de température. A titre d'exemple, on peut préciser que, pour une fibre optique monomode du commerce, le nombre de tours de torsion imposés dans chaque sens peut être par exemple de l'ordre de 80 par mètre de longueur sans prendre pour autant de risques de rupture de la fibre.

Dans le mode de réalisation de la figure 4, la même fibre 2 comporte trois sections successives 15, 16, 17 de longueurs respectives $\ell$ pour les sections 15 et 17 et $2\ell$ pour la section 16. Sur toute la longueur de la fibre 2, le nombre de tours de torsion par mètre est constant. Toutefois, les zones extrêmes 15 et 17 ont subi une torsion dans un sens et la partie centrale 16 une torsion dans le sens opposé. Comme la partie centrale a une longueur $2\ell$ égale à la somme des longueurs $\ell + \ell$ des zones extrêmes 15 et 17, il en résulte bien que la torsion résultante de la fibre 2 considérée sur toute sa longueur est nulle. Il en résulte donc également qu'on peut l'utiliser comme la fibre de la figure 3 dans un dispositif de mesure d'intensité électrique tel que celui de la figure 2 sans risquer de problème vis-à-vis des variations éventuelles de température du milieu ambiant.

Bien entendu, l'invention ne se limite nullement aux deux modes de réalisation des figures 3 et 4 ; elle inclut au contraire toutes les variantes de répartition des zones de torsion sur une même fibre, dès lors que la torsion résultante des torsions dextrogyre et sinistrogyre est nulle.

Il est bien évident toutefois, que pour utiliser un dispositif tel que décrit sur les figures 2, 3 et 4 précédentes, il est nécessaire d'éloigner à une certaine distance du capteur proprement dit la source de lumière polarisée d'une part et le dispositif de mesure ou de détection de l'autre, en prolongeant la fibre optique du capteur par deux trajets aller et retour respectivement entre la source et le capteur et entre le capteur et le détecteur. Dans certaines installations, il est nécessaire que les deux brins de fibres optiques qui assurent ces trajets aller-retour aient une longueur de plusieurs mètres par exemple.

On constate alors malheureusement que ces trajets aller-retour de la fibre optique sont très sensibles à la fois aux courbures que l'on peut imposer à ces fibres et aux vibrations auxquelles elles peuvent être soumises temporairement ou de façon permanente. En ce qui concerne les courbures, on peut évidemment les compenser pour une installation déterminée si la configuration du trajet aller-retour entre la source, le capteur et le détecteur est figée une fois pour toutes, mais ce n'est généralement pas le cas et lors de l'installation d'un dispositif de mesu-

B 7642-3AM

re d'intensité électrique à effet Faraday selon l'invention, il n'est pas possible en général de prévoir d'avance ou de fixer une fois pour toutes le trajet des fibres optiques.

Il en résulte par conséquent, si l'on désire conserver au dispositif toute sa souplesse d'emploi, la nécessité de s'affranchir de la sensibilité aux courbures et aux vibrations de cette partie du dispositif.

La présente invention permet de s'affranchir de ces problèmes par le fait que les deux brins de fibres optiques assurant les trajets aller et retour entre le capteur proprement dit d'une part et la source de lumière polarisée et le dispositif de mesure d'autre part sont constitués par une fibre optique monomode non torsadée du type à conservation de polarisation linéaire (également appelée parfois fibre à maintien de polarisation).

Dans une réalisation de ce genre, on voit donc que le dispositif global de mesure d'intensité électrique utilise deux types de fibres optiques différentes suivant la fonction à assurer :

- en ce qui concerne la partie capteur c'est-à-dire le solénoïde qui entoure le conducteur 1 parcouru par l'intensité I à mesurer, on emploie une fibre optique monomode ordinaire (par exemple les fibres ITT T 1601 ou T 1602) torsadée selon une double torsion conformément au brevet principal ;

- pour les deux brins de fibres optiques qui assurent les trajets aller-retour entre la source et le détecteur, on emploie alors une fibre optique monomode, non torsadée, à conservation de polarisation linéaire (par exemple une fibre ITT T1605) que l'on relie à la fibre optique du capteur proprement dit soit par une simple soudure, soit à l'aide de connecteurs du commerce (par exemple le connecteur "optaball" vendu sous la marque "Radiall").

Ce deuxième type de fibres optiques est en effet très peu sensible aux perturbations extérieures, car elles présentent une très forte biréfringence linéaire (typiquement de l'ordre de $10^{5°}$/m) ou, ce qui revient au même, une longueur de battement $Lp = 360°/10^5 = 3,6$ mm au lieu de quelques mètres pour les fibres optiques ordinaires. Ces caractéristiques rendent très faible le coefficient de couplage entre les deux modes propres de propagation et, de cette façon, l'état de polarisation de l'onde qui émerge d'une telle fibre dépend très peu des perturbations qu'elle peut subir le long de son trajet en matière de courbure et/ou de vibrations.

Selon une disposition secondaire, mais importante de la présente variante, des contrôleurs de polarisation sont prévus à l'entrée de la fibre "aller", c'est-à-dire à la jonction de celle-ci avec la source de lumière et à la sortie de la fibre "retour", c'est-à-dire à la jonction de celle-ci avec le dispositif de mesure pour rendre linéaire l'état de polarisation de l'onde lumineuse.

En effet, pour que le dispositif de mesure d'intensité électrique par effet Faraday, objet de la présente addition, fonctionne de façon correcte, il est nécessaire de s'assurer que l'état de polarisation de l'onde lumineuse à la sortie de la fibre "aller" (côté capteur) et à la sortie de la fibre "retour" (à l'entrée dans le détecteur) soit linéaire. C'est cette considération qui rend nécessaire l'utilisation de contrôleurs de polarisation qui permettent, d'induire par différents moyens (pressions locales, etc... ) une biréfringence contrôlée capable de restituer le caractère linéaire éventuellement déficient de la polarisation de l'onde lumineuse. De tels contrôleurs de polarisation sont parfaitement connus et décrits par exemple dans l'article "Polarization stabilisation on single mode fiber" R. Ulrich, Applied Physic Letters, 35-11(79).

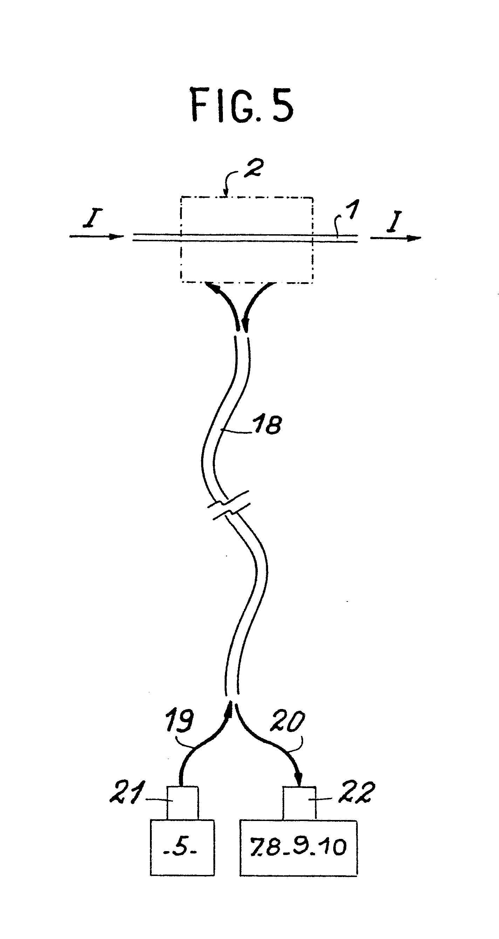

Sur la figure 5, on voit le capteur 2 traversé par le conducteur 1 parcouru par l'intensité I à mesurer, la source de lumière polarisée 5 et le dispositif de mesure ou détecteur 7, 8, 9, 10. Tous ces éléments ayant été décrits dans les exemples précédents avec les mêmes références, on ne reviendra pas sur leur constitution de détail.

Dans l'exemple décrit sur la figure 5, on voit la gaine 18 d'une longueur atteignant par exemple 4 à 5 m qui contient les deux brins de fibres optiques "aller" 19 et "retour" 20 joignant respectivement d'une part la source 5 au capteur 2 et d'autre part le capteur 2 au dispositif de mesure 7, 8, 9, 10. Selon l'invention, les deux brins de fibres optiques 19 et 20 sont constitués par une fibre optique monomode non torsadée du type à conservation de polarisation linéaire ci-dessus décrite. De plus, deux contrôleurs de polarisation d'un type connu 21 et 22 sont situés respectivement aux points de jonction du brin de fibre optique 19 et de la source 5 et du brin de fibre optique 20 du dispositif de mesure 7, 8, 9, 10.

Dans une installation conforme à celle de la figure 5, la fiabilité des indications données par le dispositif de mesure 7, 8, 9, 10 situé pourtant à plusieurs mètres de distance du capteur 2 proprement dit est pratiquement indépendante des mouvements, des torsions ou des vibrations que l'on impose à la gaine 18 et notamment à la configuration qu'on lui a donné dans l'espace au moment de l'installation du dispositif de mesure.

Dans le capteur 2, on utilise, comme déjà expliqué plus haut, une fibre optique monomode torsadée à double torsion avec un nombre égal de tours dans chaque sens.

## REVENDICATIONS

1. Dispositif de mesure d'intensité électrique à effet Faraday, du genre de ceux qui comprennent, de façon connue, une fibre optique (2) torsadée le long de son axe et enroulée en solénoïde autour du conducteur électrique (1) dans lequel circule l'intensité à mesurer, ainsi qu'à l'entrée (3) et à la sortie (6) de la fibre (2) respectivement une source de lumière polarisée (5) et des moyens de mesure (7, 8, 9, 10) de l'angle de rotation du plan de polarisation de cette lumière, parcourant la fibre, entre son entrée et sa sortie, caractérisé en ce que la fibre (2) comporte au moins deux parties torsadées en sens opposés, le nombre de tours de torsion de l'ensemble de la fibre dans un sens étant égal au nombre de tours de torsion dans l'autre sens.

2. Dispositif de mesure d'intensité électrique selon la revendication 1, caractérisé en ce que la fibre comporte deux parties (13, 14) d'égale longueur, torsadées chacune dans un sens, le sens de torsion changeant une seule fois au point milieu (12) de la longueur de la fibre (2).

3. Dispositif se mesure d'intensité électrique selon la revendication 1, caractérisé en ce que la fibre (2) comporte plusieurs parties adjacentes (15, 16, 17), le sens de torsion de la fibre (2) s'inversant à chaque point de jonction entre deux parties consécutives.

4. Dispositif de mesure d'intensité électrique selon l'une quelconque des revendications 1 à 3, caractérisé en ce que la fibre optique (2) est bloquée à ses deux extrémités et enfermée dans une gaine extérieure destinée à compenser les réactions dues aux diverses torsions.

B 7642-3 AM

5. Dispositif de mesure d'intensité électrique à effet Faraday selon la revendication 1, caractérisé en ce que les deux brins (19, 20) de fibres optiques assurant les trajets aller et retour entre le capteur proprement dit (2) d'une part et la source de lumière polarisée (5) et le dispositif de mesure (7, 8, 9, 10) d'autre part sont constitués par une fibre optique monomode non torsadée du type à conservation de polarisation linéaire.

6. Dispositif selon la revendication 1, caractérisé en ce que des contrôleurs de polarisation (21, 22) sont prévus à l'entrée de la fibre "aller" (19), c'est-à-dire à la jonction de celle-ci avec la source de lumière polarisée (5) et à la sortie de la fibre "retour" (20), c'est-à-dire à la jonction de celle-ci avec le dispositif de mesure (7, 8, 9, 10) pour rendre linéaire l'état de polarisation de l'onde lumineuse.

FIG. 1

0108012

2,4

FIG. 2

$$\frac{I_1 - I_2}{I_1 + I_2}$$

FIG. 3

FIG. 4

# FIG. 5

**Office européen des brevets**

# RAPPORT DE RECHERCHE EUROPEENNE

Numéro de la demande

EP 83 40 2046

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| Y | DE-A-2 855 337 (LICENTIA) <br> * Revendications; figures 1-4 * | 1 | G 01 R 15/07 |
| Y | MESURES - REGULATION - AUTOMATISME, vol. 47, no. 3, mars 1982, pages 65-69, Paris, FR <br> "Un capteur de courant a fibres optiques pour l'an 2000?" * En entier; figures 4,6 * | 1,3 | |
| A | US-A-4 298 245 (H. AULICH) <br> * Résumé; figure 1 * | 1 | |
| A | DE-A-2 924 804 (LICENTIA) <br> * Revendications * | 1 | |
| A | US-A-3 605 013 (S. YOSHIKAWA et al.) | | **DOMAINES TECHNIQUES RECHERCHES (Int. Cl. ³)** |
| A | FR-A-2 492 986 (COMPAGNIE GENERALE D'ELECTRICITE) | | G 01 R <br> G 01 K <br> G 01 D |

Le présent rapport de recherche a été établi pour toutes les revendications

| Lieu de la recherche | Date d'achèvement de la recherche | Examinateur |
|---|---|---|
| LA HAYE | 01-02-1984 | HAASBROEK J.N. |